# EUROPEAN PATENT APPLICATION

(11) **EP 4 585 371 A1**
(43) Date of publication of application: **16.07.2025**
(21) Application number: 24151922.2
(22) Date of filing: 15.01.2024
(51) Int. Cl.: B25F 5/00, H01H 1/36, H01H 9/00, H02K 11/215

(54) **SWITCH MODULE FOR A POWER TOOL**

(71) Applicant: Techtronic Cordless GP, Anderson, SC 29621 (US)
(72) Inventor: LI, Yong Min, Dongguan City Guangdong Province, (CN); XIE, Li Hua, Dongguan City Guangdong Province, (CN); SU, Ji Guang, Dongguan City Guangdong Province, (CN)
(74) Representative: Meissner Bolte Partnerschaft mbB

(57) **Abstract**

A switch module (10) for a power tool comprises a trigger (100) arranged to be actuated by a user, a magnet (200) coupled to the trigger (100) and configured to move along a path in response to user actuation of the trigger (100), a circuit board (300) having mounted thereon a first magnetic sensor (400) arranged at a point close to the path of the magnet (200), and a second magnetic sensor (500) arranged at a point far from the path of the magnet (200), and a motor speed controller configured to set a target speed for a motor based on an output of the first magnetic field sensor (400), and to stop the motor if an output of the second magnetic sensor (500) exceeds a predefined threshold.

## Description

### FIELD OF THE DISCLOSURE

The present disclosure relates to power tools and, in particular, to switch modules for controlling the operation of power tools.

### BACKGROUND OF THE DISCLOSURE

Existing speed control switches for DC power tools typically use metal leaf springs in contact with a carbon film track on a circuit board. The relative displacement of the metal leaf spring and carbon film alters the resistance of the carbon film which can be used for speed regulation. However, such carbon films can wear down quickly, resulting in a shorter lifespan for the tool. In some cases, such switch may have a lifespan of only 100,000 cycles.

It is an object of the present disclosure to address or at least partially ameliorate some of the above problems of the current approaches.

### SUMMARY OF THE DISCLOSURE

Features and advantages of the disclosure will be set forth in the description which follows, and in part will be obvious from the description, or can be learned by practice of the herein disclosed principles. The features and advantages of the disclosure can be realized and obtained by means of the instruments and combinations particularly pointed out in the appended claims.

In accordance with a first aspect of the present disclosure, there is provided a switch module for a power tool, comprising a trigger arranged to be actuated by a user, a magnet coupled to the trigger and configured to move along a path in response to user actuation of the trigger, a circuit board having mounted thereon a first magnetic sensor arranged at a point close to the path of the magnet, and a second magnetic sensor arranged at a point far from the path of the magnet; and a motor speed controller configured to set a target speed for the motor based on an output of the first magnetic field sensor, and to stop the motor is an output of the second magnetic sensor exceeds a predefined threshold.

The switch module may include a push rod attached to the trigger and configured to move along a linear path in response to user actuation of the trigger. The magnet and an electrical contact may be mounted at an end of the push rod distal from the trigger.

The circuit board may include a conducting track arranged such that the electrical contact travels along the conducting track in response to user actuation of the trigger.

The motor speed controller may be configured to start and stop the motor based on a voltage signal passed through the voltage track.

The push rod may be formed in a branched shape having a first branch to support the magnet and a second branch to support the electrical contact.

The electrical contact may be a leaf spring.

The first and second magnetic sensors may be Hall Effect sensors.

The first and second magnetic sensors may be configured to output a voltage signal which is proportional to the detected magnetic flux.

The switch module may include a housing, wherein the magnet and control board are arranged within the housing and the trigger and speed controller are arranged outside the housing.

In accordance with a second aspect of the present disclosure, there is provided a power tool comprising a motor and a switch module comprising a trigger arranged to be actuated by a user, a magnet coupled to the trigger and configured to move along a path in response to user actuation of the trigger, a circuit board having mounted thereon a first magnetic sensor arranged at a point close to the path of the magnet, and a second magnetic sensor arranged at a point far from the path of the magnet; and a motor speed controller configured to set a target speed for the motor based on an output of the first magnetic field sensor, and to stop the motor is an output of the second magnetic sensor exceeds a predefined threshold.

### BRIEF DESCRIPTION OF THE DRAWINGS

In order to describe the manner in which the above-recited and other advantages and features of the disclosure can be obtained, a more particular description of the principles briefly described above will be rendered by reference to specific embodiments thereof which are illustrated in the appended Figures. Understanding that these Figures depict only exemplary embodiments of the disclosure and are not therefore to be considered to be limiting of its scope, the principles herein are described and explained with additional specificity and detail through the use of the accompanying Figures.

Preferred embodiments of the present disclosure will be explained in further detail below by way of examples and with reference to the accompanying Figures, in which:-
Figure 1 is a schematic diagram of a switch module according to an embodiment.
Figure 2 is a schematic diagram of a switch module according to an embodiment.
Figure 3 is a schematic diagram of a switch module according to an embodiment.
Figure 4 is a chart showing a magnetic trace for a magnet of an embodiment.
Figure 5 is a chart showing a magnetic response curve for a first sensor of an embodiment.
Figure 6 is a chart showing a magnetic response curve for a second sensor of an embodiment.
Figure 7 is a schematic diagram of a switch module according to an embodiment.
Figure 8 is a schematic diagram of a switch module according to an embodiment.
Figure 9A is a model of the switch module according to an embodiment.
Figure 9B is a model of the switch module according to an embodiment.
Figure 10 is a schematic diagram of a switch module according to an embodiment.
Figure 11 is a schematic diagram of a power tool according to an embodiment.
Figure 12 is a schematic diagram of a power tool according to an embodiment.

### DETAILED DESCRIPTION OF THE PREFERRED EMBODIMENTS

Various embodiments of the disclosure are discussed in detail below. While specific implementations are discussed, it should be understood that this is done for illustration purposes only. A person skilled in the relevant art will recognize that other components and configurations may be used without departing from the scope of the disclosure.

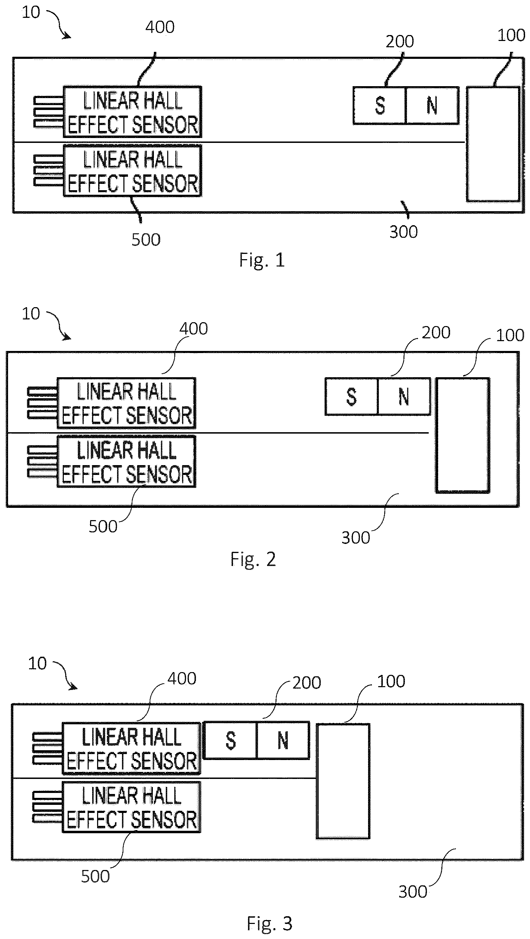

Referring to the drawings, Figure 1 is a schematic diagram of a switch module 10 for a power tool according to an embodiment. The switch module 10 comprises a trigger 100, a magnet 200, a circuit board 300, a first magnetic sensor 400, a second magnetic sensor 500 and a motor speed controller (not shown).

The trigger 100 is arranged to be actuated by a user. The trigger 100 may be configured to slide along a linear path or pivot around a pivot point. The trigger 100 is shown at an initial position, prior to actuation by a user.

The magnet 200 is coupled to the trigger 100. The magnet 200 is configured to move along a path in response to user actuation of the trigger 100. The magnet 200 may move along a linear path or arcuate path depending on the actuation of the trigger 100 and/or the coupling between the magnet 200 and the trigger 100.

Figure 2 is a schematic diagram of a switch module 10 according to an embodiment. As shown, the trigger 100 and magnet 200 are moved along a small portion of a linear path away from the initial position, after actuation by a user.

Figure 3 is a schematic diagram of a switch module 10 according to an embodiment. The trigger 100 and magnet 200 are shown at a final position after actuation by a user. As shown, the trigger 100 and magnet 200 moved along a linear path.

The circuit board 300 has a first magnetic sensor 400 and a second magnetic sensor 500 mounted thereon. The first and second magnetic sensors 400,500 may be Hall Effect sensors, or magnetoresistive elements.

The first magnetic sensor 400 is arranged at a point close to the path of the magnet 200. As shown, the magnet 200 and trigger 100 are proximate to the first magnetic sensor 400 in the final position.

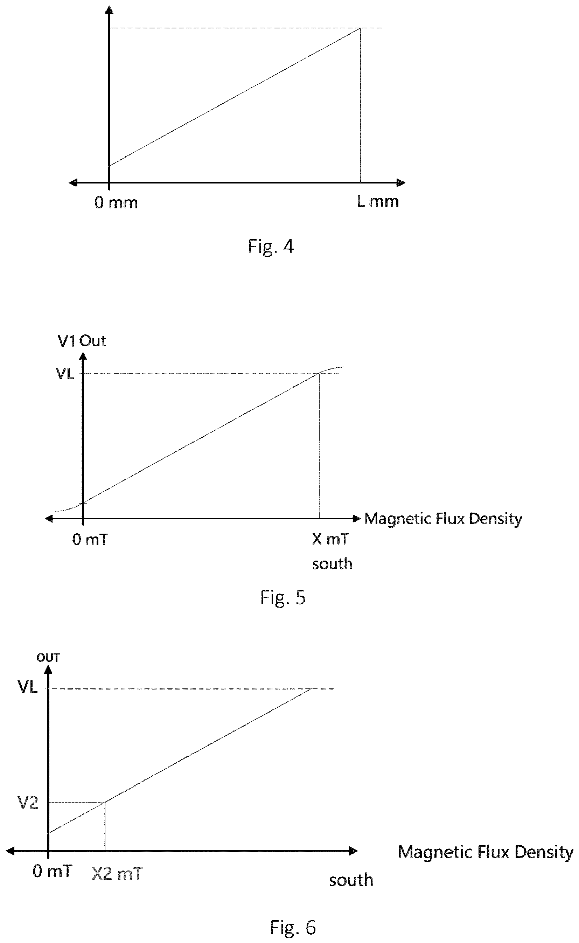

Figure 4 is a chart showing a magnetic trace for a magnet 200 of an embodiment. As shown, the effective strength of the magnet 200 may rise in a linear fashion with the distance that the magnet 200 moves along the path. The magnet 200 may move from an initial position at 0mm to final position at Lmm. The effective strength may be measured at the position of the first sensor i.e. proximate to the final position of the trigger 100 and magnet 200. The initial strength of the magnetic field at distance 0mm may be equal to the flux detected by the first magnetic sensor 400 when the magnet 200 is at the initial position.

Figure 5 is a chart showing a magnetic response curve for a first magnetic sensor 400 of an embodiment. The first magnetic sensor 400 may be configured to output a voltage signal which is proportional to the detected magnetic flux. The voltage output of the first magnetic sensor 400 may rise in a linear fashion with increasing detected magnetic field strength. In some examples, the initial voltage output of the first magnetic sensor 400 may have an initial, non-zero value when the flux detected by the first magnetic sensor 400 is zero. In some examples, the initial voltage output of the first magnetic sensor 400 may be calibrated to be zero.

The linear output relationship may be true up to a saturation limit at a magnetic flux of Xmt, where the first magnetic sensor 400 outputs a voltage signal of VL. Above the saturation limit, the relationship between magnetic flux and output voltage may be non-linear.

Based on the linear relationships shown in Figures 4 and 5, the voltage output of the first magnetic sensor 400 may be linear with respect to the distance travelled by the magnet 200 along the path. The voltage output of the first magnetic sensor 400 may be linear with respect to the distance that the trigger 100 is actuated.

The motor speed controller is configured to set a target speed for a motor based on an output of the first magnetic field sensor. The target speed may be linearly dependent on the voltage signal output by the first magnetic sensor 400. In this way, the target speed may be linearly dependent on the distance travelled by the magnet 200 along the path, and the distance that the trigger 100 is actuated. In some examples, the target speed may have a non-linear or discontinuous dependency on the voltage signal output by the first magnetic sensor 400, for example, the target speed may rise in steps or in a curve. The target speed may have an additional dependency on a further input, e.g. a speed limiter which sets a maximum speed for the motor.

The second magnetic sensor 500 is arranged at a point far from the path of the magnet 200. As shown, "far from the path of the magnet" may mean that the second magnetic sensor 500 is arranged adjacent to or away from the path of the magnet 200, and the path of the magnet 200 does not intersect with the second magnetic sensor 500.

The second magnetic sensor 500 may be a linear Hall Effect sensor, a digital switch Hall Effect sensor, a reed switch or a magnetoresistive element.

Figure 6 is a chart showing a magnetic response curve for a second sensor of an embodiment.

The second magnetic sensor 500 may be configured to output a voltage signal which is proportional to the detected magnetic flux. The voltage output of the second magnetic sensor 500 may rise in a linear fashion with increasing detected magnetic field strength. In some examples, the initial voltage output of the second magnetic sensor 500 may have an initial, non-zero value when the flux detected by the second magnetic sensor 500 is zero. In some examples, the initial voltage output of the second magnetic sensor 500 may be calibrated to be zero.

The linear output relationship may be true up to a saturation limit at a magnetic flux of Xmt, where the second magnetic sensor 500 outputs a voltage signal of VL. Above the saturation limit, the relationship between magnetic flux and output voltage may be non-linear.

In some embodiments, the second magnetic sensor 500 may output a digital voltage signal which is zero below a certain threshold and has a positive value, e.g. VL, above the threshold.

The motor speed controller is configured to stop the motor if an output of the second magnetic sensor 500 exceeds a predefined threshold.

In this way, the switch module 10 can be implemented with a contactless mechanism, which exhibits reduced wear over time. By removing sliding electrical contacts, the high wearing parts of the switch module 10 are replaced, avoiding one of the most common points of failure for such modules. The life span of the switch module 10 can be significantly extended to over 1 million cycles.

In addition, the second magnetic sensor 500 can monitor for external magnetic field interference. In this way, the reliability of the switch module 10 in different environments can be improved, in comparison with other contactless switch module 10s. By stopping the motor if the second magnetic sensor 500 output exceeds a threshold, the switch module 10 can prevent instances of the power tool unintentionally turning on, or unintended accelerations in use which can cause harm to the user.

In some examples, as shown in Figure 6, if the second magnetic sensor 500 detects a magnetic flux greater than X2 mT, the second magnetic sensor 500 may output a voltage which is greater than V2. The motor speed controller may read the voltage level of more than V2 and pause the motor drive. The motor speed controller may report an error to the user e.g. by outputting a light or sound signal. The motor speed controller may stop the motor in response to a sudden change in magnetic flux i.e. based on a minimum slope gradient of magnetic flux detected by the second magnetic sensor 500 and/or a threshold extent of change in magnetic flux detected by the second magnetic sensor 500.

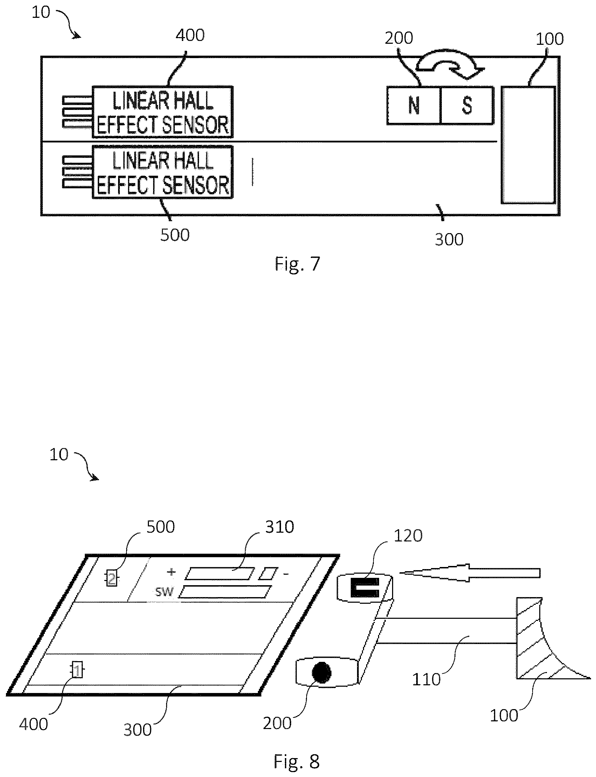

Figure 7 is a schematic diagram of a switch module 10 according to an embodiment. As shown, the magnet 200 may be arranged with the poles in either direction. The north pole or the south pole of the magnet 200 may face towards the first magnetic sensor 400. The magnet 200 may be any known permanent magnet, e.g. a Nd2Fe14B magnet, SmCo magnet, ALNiCO magnet, FeCrCo magnet etc. The strength of the magnet 200 may be, for example, from approximately 10mT to 1.5T. In some examples, the strength of the magnet 200 may be higher or lower than this range, according to requirements.

The switch module 10 may include a push rod attached to the trigger 100 and configured to move along a linear path in response to user actuation of the trigger 100. This can allow the trigger 100 to be mounted externally on a housing of the power tool, while the magnet 200 and circuit board 300 can be mounted inside the housing.

Figure 8 is a schematic diagram of a switch module 10 according to an embodiment. As shown, the magnet 200 may be mounted at an end of the push rod 110 distal from the trigger 100. The distance travelled by the magnet 200 from the initial position to the final position may be approximately 4mm to 8mm. In some examples, the path travelled by the magnet 200 may be longer or shorter, according to the requirements of the power tool. For example, larger or smaller tools may have longer or smaller paths, respectively.

The distance between the first and second magnetic sensors 400,500 may be approximately 5mm to 15mm. In some examples, the distance between the first and second magnetic sensors 400,500 may be longer or shorter, according to the calibration of the sensors and the requirements of the tool. For example, the distance may be dependent on the strength of the magnet 200 used.

An electrical contact 120 may be mounted at an end of the push rod 110 distal from the trigger 100. The push rod 110 may be formed in a branched shape having a first branch to support the magnet 200 and a second branch to support the electrical contact 120. For example, the push rod 110 may have a T-shape or Y-shape.

The circuit board 300 may include a conducting track 310 arranged such that the electrical contact 120 travels along the conducting track 310 in response to user actuation of the trigger 100. The electrical contact 120 may be a leaf spring. The motor speed controller may start and stop the motor based on a voltage signal passed through the conducting track 310. In this way, the reliability of a start-stop control based on a physical electric contact can complement the contactless speed control. Overall, the usability and reliability of the switch module 10 is balanced with improved wear over time.

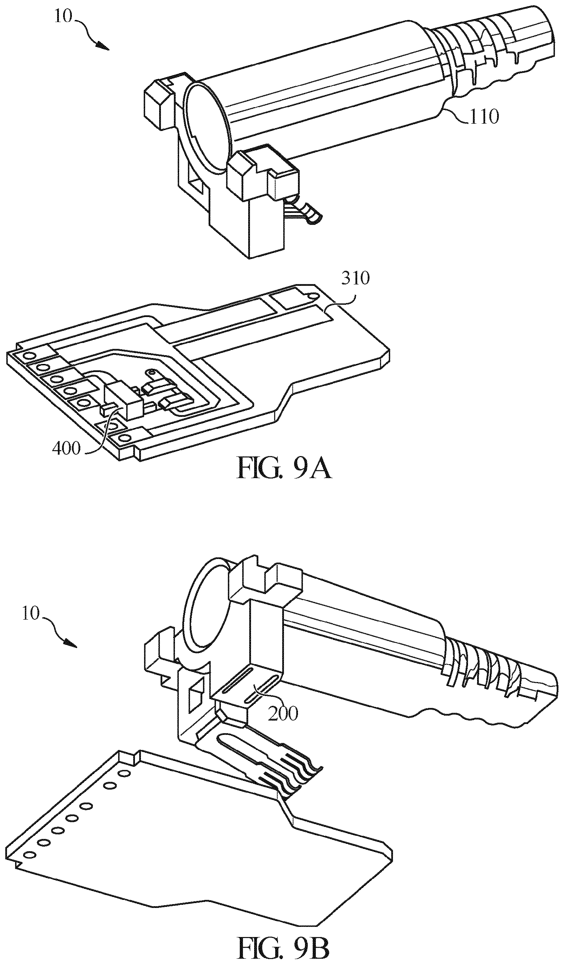

Figure 9A is a model of the switch module 10 according to an embodiment. As shown, a power leaf spring may be arranged at the distal end of the push rod 110. The conducting track 310 may be formed in two lines extending along the path of the power leaf spring 120. A first line of the conducting track 310 may be continuous and may be referred to as a source contact. The source contact may be connected to the motor. A second line of the conducting track 310 may be broken into a ground contact and an active contact. The ground contact may be connected to ground, and the active contact may be connected to the power supply.

In an initial position of the push rod 110, the power leaf spring 120 may connect the source contact with the ground contact. In this position, the motor may be connected to ground. As the push rod 110 is moved along the path towards the final position, the power leaf spring 120 may connect the source contact with the active contact. The motor may be connected with the power supply and activated. Alternatively, the source contact may be connected to the power supply and the active contact connected to the motor. Alternately, the source contact and active contact may be connected with pin connections of the motor speed controller. The motor speed control may activate the motor based on the signals received from the source contact and active contact.

Figure 9B is a model of the switch module 10 according to an embodiment. As shown, the magnet 200 may be arranged adjacent to the power leaf spring 120 at the distal end of the push rod 110. The push rod 110 may be formed with a perpendicular protrusion to attach the magnet 200 and/or the electrical contact 120. The magnet 200 may be retained within the push rod 110.

The switch module 10 may include a housing, wherein the magnet 200 and circuit board 300 are arranged within the housing and the trigger 100 and speed controller are arranged outside the housing. The housing may be formed from a plastic material such as polyamide (PA11, PA6, PA46 PA66 etc.), polypropylene or any other suitable polymer. The polymer may be reinforced with glass fibre in a ratio of e.g. 10% to 50%. In some examples, the housing may include a magnetic shielding cover to further reduce the influence of external magnetic fields.

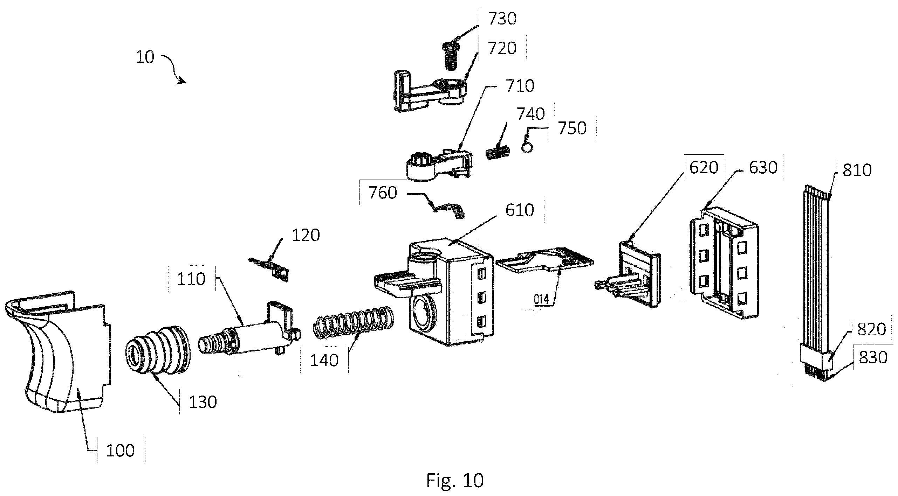

Figure 10 is a schematic diagram of a switch module 10 according to an embodiment. As shown, the housing may include a main housing 610, middle housing 620 and cover 630. The switch module 10 may include a forward/reverse switch, configured to send a forward or reverse signal to the motor speed controller. The motor speed controller may control the motor to operate in a forwards or reverse direction according to the signal from the forward/reverse switch. The switch module 10 may include a slide block 710 and lever 720. The lever 720 may form the forward/reverse (F/R) switch.

The slide block 710 may be arranged within the main housing 610, with a rotatable portion extending through an opening in the main housing 610. The lever 720 may be attached to the rotatable portion with a screw 730, such that rotation of the lever 720 causes the slide block 710 to rotate within the main housing 610. A small spring 740 and steel ball 750 may assist the smooth rotation of the slide block 710.

The forward/reverse switch may be coupled to a leaf spring contact 760, in contact with a conducting track on the circuit board 300. F/R leaf spring 760 may be connected with the slide block 710 and may be arranged to contact an F/R conducting track on the circuit board 300. In this way, the lever 720 may be used to control a forward or reverse direction of the motor. The circuit board 300 may be connected with a plurality of wires 810, through a wire terminal holder 820 to a wire terminal 830. The wire terminal may be connected with the motor speed controller of the switch module 10.

A dustproof boot 130 may be arranged between the trigger 100 and push rod 110. Power leaf spring 120 may be connected to the push rod 110 and arranged to contact the circuit board 300. The magnet 200 may be arranged at the distal end of the push rod 110. A compressive spring 140 may be arranged between the push rod 110 and the middle housing, to urge the push rod 110 in a direction towards the trigger 100. In this way, the trigger 100 and push rod 110 are held in the initial position unless actuated by a user.

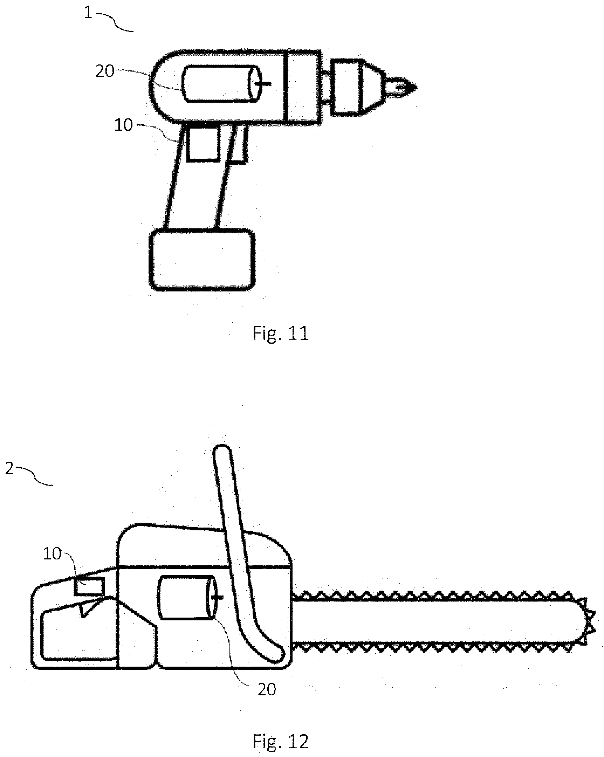

Figure 11 is a schematic diagram of a power tool 1 according to an embodiment. The power tool 1 may be, for example, a handheld power drill.

The power drill 1 may include a motor and a switch module 10. The motor 20 may be an AC or DC motor. The motor 20 may be a brushed or brushless motor. The power drill 1 may include a power supply. The power supply may be an internal battery, removable battery, mains supply connection or any other suitable power supply.

The switch module 10 comprises a trigger 100 arranged to be actuated by a user, a magnet 200 coupled to the trigger 100 and configured to move along a path in response to user actuation of the trigger 100, a circuit board 300 having mounted thereon a first magnetic sensor 400 arranged at a point close to the path of the magnet 200, and a second magnetic sensor 500 arranged at a point far from the path of the magnet 200, and a motor speed controller configured to set a target speed for the motor 20 based on an output of the first magnetic field sensor, and to stop the motor 20 if an output of the second magnetic sensor 500 exceeds a predefined threshold.

Figure 12 is a schematic diagram of a power tool 2 according to an embodiment. The power tool may be, for example, a chainsaw.

The chainsaw 2 may include a motor 20 and a switch module 10. The motor may be an AC or DC motor. The motor 20 may be a brushed or brushless motor. The chainsaw 2 may include a power supply. The power supply may be an internal battery, removable battery, mains supply connection or any other suitable power supply.

The switch module 10 comprises a trigger 100 arranged to be actuated by a user, a magnet 200 coupled to the trigger 100 and configured to move along a path in response to user actuation of the trigger 100, a circuit board 300 having mounted thereon a first magnetic sensor 400 arranged at a point close to the path of the magnet 200, and a second magnetic sensor 500 arranged at a point far from the path of the magnet 200, and a motor speed controller configured to set a target speed for the motor 20 based on an output of the first magnetic field sensor, and to stop the motor 20 if an output of the second magnetic sensor 500 exceeds a predefined threshold.

In addition to the examples shown in Figures 10 and 11, the power tool may be embodied as, for example, a hedge trimmer, string trimmer, lawnmower, blower, washer, vacuum cleaner or any other suitable tool or appliance.

The above embodiments are described by way of example only. Many variations are possible without departing from the scope of the disclosure as defined in the appended claims.

For clarity of explanation, in some instances the present technology may be presented as including individual functional blocks including functional blocks comprising devices, device components, steps or routines in a method embodied in software, or combinations of hardware and software.

Methods according to the above-described examples can be implemented using computer-executable instructions that are stored or otherwise available from computer readable media. Such instructions can comprise, for example, instructions and data which cause or otherwise configure a general purpose computer, special purpose computer, or special purpose processing device to perform a certain function or group of functions. Portions of computer resources used can be accessible over a network. The computer executable instructions may be, for example, binaries, intermediate format instructions such as assembly language, firmware, or source code. Examples of computer-readable media that may be used to store instructions, information used, and/or information created during methods according to described examples include magnetic or optical disks, flash memory, Universal Serial Bus (USB) devices provided with non-volatile memory, networked storage devices, and so on.

Devices implementing methods according to these disclosures can comprise hardware, firmware and/or software, and can take any of a variety of form factors. Typical examples of such form factors include laptops, smart phones, small form factor personal computers, personal digital assistants, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are means for providing the functions described in these disclosures.

Although a variety of examples and other information was used to explain aspects within the scope of the appended claims, no limitation of the claims should be implied based on particular features or arrangements in such examples, as one of ordinary skill would be able to use these examples to derive a wide variety of implementations. Further and although some subject matter may have been described in language specific to examples of structural features and/or method steps, it is to be understood that the subject matter defined in the appended claims is not necessarily limited to these described features or acts. For example, such functionality can be distributed differently or performed in components other than those identified herein. Rather, the described features and steps are disclosed as examples of components of systems and methods within the scope of the appended claims.

## Claims

1. A switch module for a power tool, comprising:
a trigger arranged to be actuated by a user;
a magnet coupled to the trigger and configured to move along a path in response to user actuation of the trigger;
a circuit board having mounted thereon a first magnetic sensor arranged at a point close to the path of the magnet, and a second magnetic sensor arranged at a point far from the path of the magnet; and
a motor speed controller configured to set a target speed for the motor based on an output of the first magnetic field sensor, and to stop the motor is an output of the second magnetic sensor exceeds a predefined threshold.

2. The switch module of claim 1, further comprising a push rod attached to the trigger and configured to move along a linear path in response to user actuation of the trigger, wherein the magnet and an electrical contact are mounted at an end of the push rod distal from the trigger;
wherein the circuit board further comprises a conducting track arranged such that the electrical contact travels along the conducting track in response to user actuation of the trigger; and
wherein the motor speed controller is configured to start and stop the motor based on a voltage signal passed through the voltage track.

3. The switch module of claim 2, wherein the push rod is formed in a branched shape having a first branch to support the magnet and a second branch to support the electrical contact.

4. The switch module of claim 2 or claim 3, wherein the electrical contact is a leaf spring.

5. The switch module of any preceding claim, wherein the first and second magnetic sensors are Hall Effect sensors.

6. The switch module of any preceding claim, wherein the first and second magnetic sensors are configured to output a voltage signal which is proportional to the detected magnetic flux.

7. The switch module of any preceding claim, further comprising a housing, wherein the magnet and control board are arranged within the housing and the trigger and speed controller are arranged outside the housing.

8. A power tool comprising:
a motor; and
a switch module according to any preceding claim.
